(19) Europäisches Patentamt
European Patent Office
Office européen des brevets

(11) **EP 2 818 859 A1**

(12) **EUROPEAN PATENT APPLICATION**

(43) Date of publication:
**31.12.2014 Bulletin 2015/01**

(51) Int Cl.:
***G01N 30/16*** *(2006.01)*     ***G01N 30/86*** *(2006.01)*

(21) Application number: **13003300.4**

(22) Date of filing: **28.06.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Ruprecht-Karls-Universität Heidelberg
69117 Heidelberg (DE)**

(72) Inventors:
• **Trapp, Oliver**
  **69221 Dossenheim (DE)**
• **Siegle, Alexander F.**
  **69126 Heidelberg (DE)**

(74) Representative: **Müller-Boré & Partner
Patentanwälte PartG mbB
Friedenheimer Brücke 21
80639 München (DE)**

(54) **Chromatographic Device and Method**

(57) A chromatographic device (10) for analysing multiple samples comprises a separator (22) for separating the multiple samples, an injector unit (15) for injecting the multiple samples into the separator (22), the injector unit (15) being provided as regular injector unit for single-sample chromatography, a detector (24) for detecting signals of the multiple samples after they are separated by the separator (22), a sequence generator (12) for generating a specific binary sequence for each of the multiple samples, a controller (12) that controls the injector unit (15) so that each of the multiple samples is injected into the separator (22) in pulses corresponding to its specific binary sequence, and a decomposer (12) for decomposing the detected signals of the multiple samples by identifying the specific binary sequences in the detected signals.

```
┌─────────────────────┐     ┌──────────────────────────┐
│ Construction of a   │     │ Filling of the sequence  │
│ binary sequence     │ ──▶ │ with n 0's or 1's        │ ──▶
│ 101001011 by        │     │ between the elements     │
│ software or         │     │ 100000000010000000000000 │
│ hardware encoding   │     │ 010000000001000010000    │
└─────────────────────┘     └──────────────────────────┘

┌────────────────────────┐   ┌──────────────────────┐   ┌──────────────────┐
│ Transmission of the    │   │ Processing of the    │   │ Detection of the │
│ sequence and command   │   │ commands according   │   │ multiplexed      │
│ macro to control       │──▶│ to the precise       │──▶│ signals          │
│ position of the        │   │ timing of the clock  │   └──────────────────┘
│ autosampler as digital │   │ of the analytical    │
│ or electronic data by  │   │ device/ autosampler  │
│ wire, wireless, USB,   │   └──────────────────────┘
│ flash memory, etc. to  │
│ the controller/ memory │
│ of the analytical      │
│ device/ autosampler    │
└────────────────────────┘
```

Figure 1

## Description

The invention relates to a chromatographic device, a method for analysing samples in a chromatographic device, and a computer program product.

Various methods and apparatuses are known in the prior art for qualitative and/or quantitative analysis, that is to say for determining the type and/or quantity of the components of a substance mixture, which use chemical/physical and/or biochemical methods and various separating techniques.

In order to identify and/or quantify chemical compounds in complex chemical and/or biochemical substance mixtures to be analysed, particularly in the case of the analysis of complex chemical substance mixtures from high throughput methods, use is made of chromatographic separating methods and/or devices, where the substance mixtures to be analysed are analysed sequentially. Analysing each substance mixture in a chromatograph can take hours.

Document DE 10 2005 050 114 relates to the analysis of multiple samples as substance mixtures in a gas-phase chromatograph. The gas-phase chromatograph comprises a specific, additional injector unit comprising multiple capillary tubes for different samples provided in a revolver-like arrangement. This revolver-like injector unit injects the multiple samples in a specific sequence in a separator of the gas-phase chromatograph so that multiple samples are arranged in the separator at the same time. A detector of the gas-phase chromatograph detects signals of the substances of the multiple samples in a multiplexed manner. Out of these multiplexed detected signals, an analysis of the individual samples can be derived. The revolver-like injector unit allows, thus, to analyse multiple samples in a multiplexed manner and increases the total number of samples analysed in the gas-phase chromatograph per time.

While the above revolver-like injector unit improves the speed of the analysis considerably, its installation is complicated and expensive.

Thus, according to an aspect, it is an object to provide an improved way to chromatographically analyse samples.

The achievement of this object in accordance with the invention is set out in the independent claims. Further embodiments of the invention are the subject-matter of the dependent claims.

One aspect of the invention relates to a chromatographic device for analysing multiple samples comprising a separator for separating the multiple samples, an injector unit for injecting the multiple samples into the separator, and a detector for detecting signals of the multiple samples after they are separated by the separator. Therein, the injector unit is provided as regular injector unit for single-sample chromatography. A sequence generator generates a specific, e.g. individual binary sequence for each of the multiple samples. A controller controls and/or drives the injector unit so that each of the multiple samples is injected into the separator in pulses corresponding to its specific binary sequence. A decomposer decomposes the detected signals of the multiple samples by identifying at least one of the specific binary sequences in the detected signals.

The chromatographic device can be arranged as a gas chromatography (GC) system, as a high-performance liquid chromatography (HPLC) system, as a capillary electrophoresis system, as a supercritical fluid chromatography (SFC) system, or as one of these in their modified form, e.g. ultra high-performance liquid chromatography (UHPLC) system instead of HPLC system, etc. In particular, the chromatographic device can be implemented as one form of liquid chromatography (LC) system, meaning that in particular the separator is implemented as an LC separator.

The multiple samples can be provided as substance mixtures, in particular complex chemical and/or biochemical substance mixtures. The multiple samples may be all different from each other, e.g. by comprising different substance mixtures or by comprising the same substance mixture in different concentrations. Alternatively, some or all samples might be repeatedly used, e.g. twice or three times, to verify the analysis of this sample.

The individual samples of the multiple samples are consecutively injected into the separator by the injector unit. For this task, the injector unit may comprise a capillary tube, in particular a single capillary tube, to hold the individual sample that is to be injected. The individual sample that is processed is injected into the separator in well defined and controlled pulses. These pulses correspond to the specific binary sequence, e.g., the individual sample is only injected in a pulse for every element "1" of the specific binary sequence, while it is not injected for every element "0" of the specific binary sequence.

The injector unit is provided and arranged as a regular injector unit for single-sample chromatography. Such a regular injector unit usually comprises exactly one channel for the sample. Thus, a regular injector is usually able to operate and hold only one sample at a time. The controller directly controls the regular injector unit without the need of a special additional injector unit like the revolver injector known from the prior art. The controller helps to save both the cost and the installation of the additional special injector unit. In other words, a regular injector unit can also be referred to as a conventional injector unit. According to one definition a conventional injector unit is adapted to operate and hold only one sample at a time. According to this definition instead of the term regular injector unit or the term conventional injector unit the term injector unit being adapted to operate and hold only one sample at a time may be used. Hence, a conventional injector unit comprises means such that it is operable to hold exactly one sample at a time.

The sequence generator generates and/or provides at least one specific binary sequence for each individual sample of the multiple samples. The specific binary sequences of the multiple samples differ from each other and, thus, enable identifying of the individual samples in the final chromatogram.

After one, e.g. the first, of the multiple samples is injected in its specific, e.g. the first, binary sequence, the injector unit takes the next, e.g. the second, of the multiple samples and injects it according to its own specific, e.g. second, binary sequence into the separator.

The timing, operation, and driving of the injection unit is controlled by the controller. The controller can be implemented as an electronic circuit and/or microprocessor executing computer readable, e.g. coded, instructions.

Since the substances of the individual samples usually need different time to pass through the separator, some substances of one sample will pass some substances of the preceding and/or succeeding sample within the separator. This may cause overlapping, multiplexed signals at the detector.

The decomposer decomposes the multiplexed signals that are detected at the detector. The decomposer may comprise a processor to analyse and process the detected data signals of the substances of the multiple samples after the multiple samples pass through the separator. According to the respective specific binary sequence in which each of the multiple samples was injected, each kind of substance of the respective sample appears in the chromatogram in exactly this specific binary sequence which allows the associated sample to be identified and, thus, the retention time it spent in the separator. In particular, the decomposer may identify the respective specific binary sequence of one of the samples repeatedly in the multiplexed signals, namely once for each respective substance of the sample. The multiplexed detected signals can be decomposed by a mathematical deconvolution so that conventional chromatograms of each of the multiple samples are obtained. A conventional chromatogram is provided as single sample chromatogram without multiplexing samples.

The controller is able to communicate with the decomposer through electronic binary data or by direct and/or indirect electronic signals. In particular, the controller may be coupled to communicate with both the sequence generator and the decomposer to exchange binary data. The controller may control not only the injecting process of the injector unit, but also the sequence generator and the decomposer to analyse the multiple samples. The specific binary sequence is transmitted by the controller and/or the sequence generator to the decomposer which is implemented as an analysis tool to qualify the substances of the samples. The specific binary sequence may be transmitted directly or indirectly, by electronic signals or as stored data to the decomposer. This transfer to the decomposer may be executed in real time, with a time offset or as a whole sequence. Thus, the controller may serve as link and controller of the sequence generator, the injector unit, and/or the decomposer.

Such a multiplexing system significantly increases the sample throughput without the use of a special injection unit and/or system. The multiplexing system can be transmitted to the analysis system through electronic binary sequences or by direct and/or indirect electronic signals.

The chromatographic device enables analysing a variety of multiple samples each comprising a different composition or the same sample repeatedly as multiple samples. In contrast to conventional analysis, several sample injections are analysed and shown in a multiplexed chromatogram that shows multiplexed detected signals.

The chromatographic device improves existing conventional chromatographic analysis instruments by increasing the sample throughput through a multiplexing system without the need for changing the hardware components.

According to an embodiment, the controller controls and/or drives the injector unit and the timing of the pulses according to the specific binary sequence based on computer readable instructions. The controller can be implemented as computer readable instructions and/or as an electronic circuit that overwrite(s) an existing regular control of electronic circuits of the chromatographic device. In particular, the controller can be implemented as computer readable instructions that, when installed, transform a regular sequential chromatographic device into a multiplexing chromatographic device without changing any hardware component. This can, e.g. be achieved by the controller overwriting firmware of the chromatographic device. This increases the throughput of a regular chromatographic device many times over.

According to an embodiment, the chromatographic device comprises multiple injector units each being provided as regular injector unit for single-sample chromatography, wherein the controller controls each of the multiple injector units. All injector units inject samples for the same chromatogram. By controlling multiple regular injector units, the timing for the injection of the samples can be further improved.

According to an embodiment, the controller controls the sample-volume injected into the separator at each pulse. The controller may, thus, not only control the time interval of the pulses during that each of the multiple samples is injected into the separator, but also the sample-volume of each pulse, which gives the specific binary sequence an additional dimension to multiplex the data.

In an embodiment, the chromatographic device comprises a timer according to which the controller controls the time length of the pulses in which the multiple samples are injected into the separator. The timer can be implemented as a quartz crystal known from watches. According to the timing provided by the timer, the controller may control both the time length of the pulses and the time length of the pauses between the pulses. Preferably, the pulses are very short to provide Dirac-like pulses that increase the accuracy of the multiplexed chromatogram.

According to an embodiment, the sequence generator generates the specific binary sequence as a pseudo-random binary sequence, e.g. by an unambiguous method, comprising substantially the same number of elements "0" and of elements "1". The sequence generator then generates an extended specific binary sequence by filling the specific binary sequence with a predetermined number of elements "0" or elements "1" before or after each respective element of the specific binary sequence. Thus, the elements of the specific binary sequence are filled with a fixed, but arbitrary number of same elements "0" or "1" which contributes to "sharpen" the pulses of the injector unit. In this embodiment, the controller controls and/or drives the injector unit so that each of the multiple samples is injected into the separator in pulses corresponding to its extended specific binary sequence. The decomposer decomposes the detected signals of the multiple samples by identifying at least one of the extended specific binary sequences in the detected signals. For example, the sequence generator may add four elements "0" after each element of the specific binary sequence which increases the contrast provided by the elements "1" in the extended specific binary sequence. The longer the chosen filling sequences of elements "1" or "0", the shorter and more precise the sample pulse becomes, preferably a Dirac-like pulse. Preferably, the filling sequence consists of F elements "0" or "1", wherein $1 \leq F \leq \infty$, preferably $40 \leq F \leq 10000$, more preferably $200 \leq F \leq 1200$.

Therein, the sequence generator may generate the specific binary sequence as pseudo-random sequence from $2^n - 1$ elements, wherein $1 \leq n \leq \infty$, preferably $5 \leq n \leq 128$, more preferably $5 \leq n \leq 13$. The natural number n defines how many different specific binary sequences can be generated to identify the samples. The larger n is chosen, the more different samples can get multiplexed in the chromatographic device.

In an embodiment, the sequence generator generates the specific binary sequence by means of an electronic circuit and/or computer readable instructions. A random number generator may be used to help generating the specific binary sequence.

In an embodiment, the controller drives the injector unit so that each of the multiple samples is injected into the separator in pulses at equidistant time intervals corresponding to binary elements of the specific binary sequence. Each element of the specific binary sequence is associated with the time interval. Either at each element "0" or at each element "1" of the specific binary sequence, a sample pulse is injected into the separator, while the injection is paused during the other kind of element.

Therein, the equidistant time intervals $\Delta t$ last from 500 ms to 240 s, preferably from 1 s to 60 s. The equidistant time interval $\Delta t$ is assigned to each element of the specific binary sequence.

In the embodiment wherein the sequence generator fills the specific binary sequence with F filling elements to form the extended specific binary sequence, each element of the extended specific binary sequence is assigned to an reduced time interval $\Delta t_{reduced}$ that is given by

$$\Delta t_{reduced} = \Delta t / (F+1).$$

Thus, for an exemplary specific binary sequence "1001" with an exemplary time interval $\Delta t = 1$ s and an exemplary filling sequence length of F=100, a reduced time interval $\Delta t_{reduced}$ will be defined as: $\Delta t_{reduced}$ = 1 s / (100+1) $\approx$ 10 ms. In the exemplary embodiment, the injection will be executed as follows: The sample to which the specific binary sequence is assigned will get injected within a time interval of 10 ms. After waiting 1 second minus the time of injection ($\Delta t$ minus $\Delta t_{reduced}$), the injection will pause for two seconds, and then another sample pulse will become injected. The injecting process is controlled and driven by the controller operating the injection unit. Typical time intervals for a complete injection process of a sample in its assigned specific binary sequence for an HPLC system may be executed in less than around 18 s. The multiplexing with such time intervals is well practicable and increases the throughput of a regular single-sample chromatographic device.

One aspect relates to a method for analysing multiple samples in a chromatographic device comprising the steps:

- generating a specific binary sequence for each of the multiple samples,
- controlling a regular injector unit for single-sample chromatography so that the injector unit injects each of the multiple samples into a separator of the chromatographic device in controlled pulses corresponding to the specific binary sequence of the sample,

- separating the multiple samples in the separator,
- detecting signals of the separated multiple samples, and
- decomposing the detected signals of the separated multiple samples by identifying at least one of the specific binary sequences in the detected signals.

The specific binary sequences may either be generated at once before the start of the analysing process, or generated when switching to the succeeding sample to be analysed.

In particular, the method may comprise a direct control of the injecting of the multiple samples by computer readable instructions, e.g., by a controller comprising a processor.

The method may be carried out to analyse multiple samples in a chromatographic device described above.

One aspect relates to a computer program product comprising computer readable instructions which when loaded and executed by a processor cause the processor to carry out the method described above. The computer readable instructions may be stored on a computer readable storage device and/or may be provided by a computer readable stream.

In the following, the invention will be described by way of example, without limitation of the general inventive concept, with the aid of embodiments with reference to the drawings to which attention is drawn concerning the disclosure of all details of the invention not described more explicitly in the text. Some features shown in the different embodiments can be exchanged into the implementations shown in another embodiment. Shown by

Fig. 1     is a schematic flowchart of a method to inject and analyse multiple samples in a chromatographic device;

Fig. 2     is a diagram of experimentally detected multiplexed signals in an HPLC chromatogram using an 11-bit coding;

Fig. 3A    is a diagram of experimentally detected multiplexed signals in an HPLC chromatogram using an 8-bit coding;

Fig. 3B    is an enlarged section of the diagram shown in Fig. 3A;

Fig. 4A    is a diagram of experimentally detected multiplexed signals in an HPLC chromatogram using a 7-bit coding;

Fig. 4B    is a diagram of the chromatogram shown in Fig. 4A after its decomposition;

Fig. 5A    is a diagram of experimentally detected multiplexed signals in an HPLC chromatogram of a chiral separation using an 8-bit coding at a time interval of 45 s;

Fig. 5B    is a diagram of the chromatogram shown in Fig. 5A after its decomposition;

Fig. 6     is a schematic flowchart of a method to inject encoded multiple samples in a chromatographic device and to analyse them afterwards;

Fig. 7     is a diagram showing a reaction profile obtained by high-throughput HPLC multiplexing;

Fig. 8A    is a diagram of experimentally detected multiplexed signals in an HPLC chromatogram using a 9-bit coding at a time interval of 30 s;

Fig. 8B    is a diagram of a chromatogram of one of the samples decomposed from the chromatogram shown in Fig. 8A;

Fig. 8C    is a diagram of the fully decomposed chromatogram of Fig. 8A;

Fig. 9     is a schematic setup of a method to apply binary sequences to a chromatographic device;

Fig. 10    is a schematic setup of a method to transmit executive commands to an injector unit of a chromatographic device; and

Fig. 11    is a schematic flowchart of a method to control an injector unit according to a binary sequence.

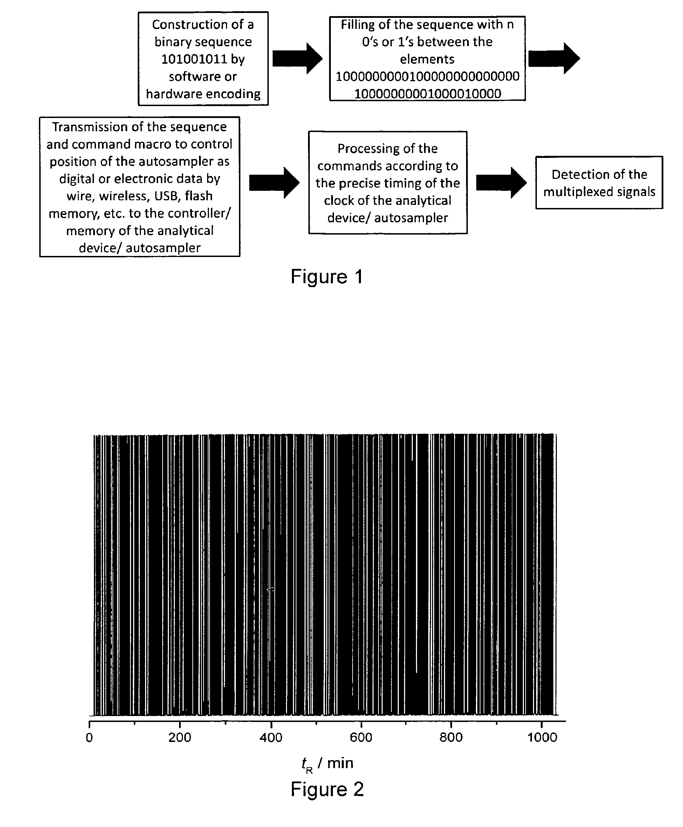

**Fig. 1** shows a schematic flowchart of a method to inject and to analyse multiple samples in a chromatographic device. Before any sample to be analysed in a chromatographic device is injected into a separator, a sequence generator generates a pseudo-random sequence as specific binary sequence with elements "1" and "0". The pseudo-random sequence is generated by software or hardware encoding. In the example shown by Fig. 1, a 9-bit sequence is generated with the nine elements "101001011". The generated specific binary sequence comprises substantially the same number of elements "1" as elements "0". In the example, the specific binary sequence comprises five elements "1" and four elements "0". This helps read out and identify the sequence later in the chromatogram. Comprising substantially the same number of elements "1" and "0" may mean that the number of elements "0" equals $\pm 1$ the number of elements "1".

In another step, the pseudo-random sequence is filled with four additional filling elements "0" after each element. The resulting sequence is used as extended specific binary sequence associated with one sample to be analysed in the chromatographic device. The filling of the specific binary sequence with additional filling elements of the same kind helps to sharpen the peaks in the chromatogram. In particular, the specific binary sequence is filled with that element of the kind that will result in no injection, but in a pause of the injection. This leads to very short and sharp pulses in the injecting spectrum, similar to ideal Dirac-pulses. In the example, this leads to the extended specific binary sequence "10000 00000 10000 00000 00000 10000 00000 10000 10000".

The extended specific binary sequence is now transmitted to the controller that controls and/or drives an injector unit of the chromatographic device. The extended specific binary code can be transmitted as digital and/or electronic data by wire, wireless LAN, USB stick, flash memory, etc.

The controller processes and drives the injector unit according to a precise timing sequence in pulses that correspond to the exact extended specific binary sequence. A timer and/or clock helps to tact the pulses.

In the example shown in Fig. 1, a time interval $\Delta t$ is associated to each element of the specific binary sequence. Therefore, each element of extended specific binary sequence is associated to a reduced time interval $\Delta t_{reduced}$ that is a fraction (depending on the number of filling elements F) of the time interval $\Delta t$. The controller will drive the injector unit so that it injects the sample for a pulse of the reduced time interval $\Delta t_{reduced}$ having a

predetermined time length for every element "1" in the extended specific binary sequence while it will not inject the sample for every element "0" for the exact same reduced time interval $\Delta t_{reduced}$. In the example, a predetermined time interval $\Delta t$ is chosen for 30 seconds. This results in a reduced time interval $\Delta t_{reduced}$ of six seconds (since the number F of fillings elements equals four) and in the controller controlling the injector unit so that it will inject the sample as follows:

- 6 second time interval for an injection pulse (one element "1"),
- pause for 54 seconds (nine elements "0"),
- 6 second time interval for an injection pulse (one element "1"),
- pause for 84 seconds (fourteen elements "0")
- 6 second time interval for an injection pulse (one element "1"),
- pause for 54 seconds (nine elements "0"),
- 6 second time interval for an injection pulse (one element "1"),
- pause for 24 seconds (four elements "0"),
- 6 second time interval for an injection pulse (one element "1"), and
- pause for 24 seconds (four elements "0").

Afterwards, the controller will let the injector unit pick up the next sample and control its injection into the separator according to another extended specific binary sequence.

This leads to multiplexed signals at the detector of the chromatographic device, since some substances of the samples will pass each other in the separator. According to the extended specific binary sequence in which the signals of the respective substances appear in the chromatogram, they can be associated with their sample and, thus, with the time they spent in the separator.

Fig. 2 shows an experimental diagram of multiple, sequential specific binary sequences in which one sample is repeatedly injected into a chromatographic device. Fig. 2 shows a diagram of experimentally detected multiplexed signals in an HPLC chromatogram using an 11-bit coding (for the specific binary sequence) and a time interval $\Delta t$ of 30 seconds. Thus, measurements with a large number of injections are possible with a high stability (e.g., 1024 injections). A continuous quality control can be achieved by this method. In a (conventional) injection interval of 30 seconds, this corresponds to a continuous measurement duration of 17 hours and, thus, to a longer monitoring of a reaction process.

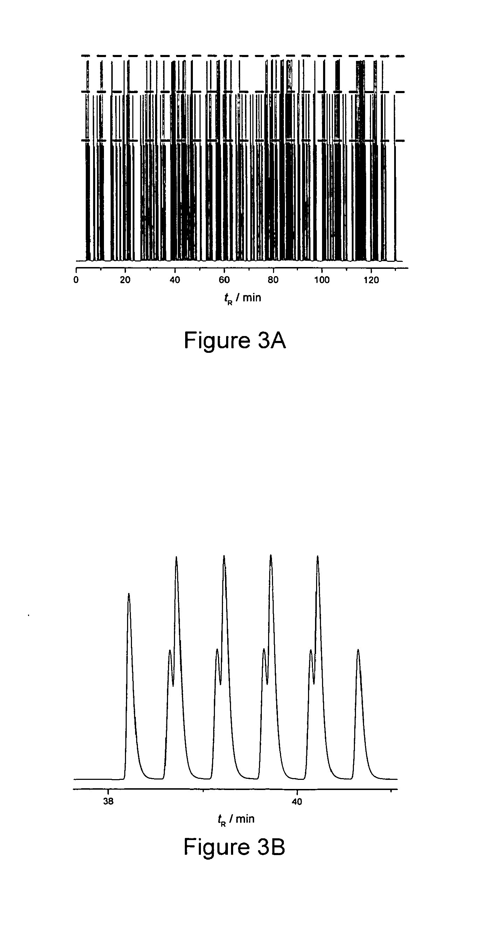

Fig. 3A shows a diagram of experimentally detected multiplexed signals in an HPLC chromatogram using a 8-bit coding. The multiplexed chromatogram shows at least three different heights $h_1$, $h_2$, and $h_3$ of two different substances caused by convolution of the signals. In the multiplexed chromatogram, the substances appear in sharp peaks showing widths according to the pulse length during which they were injected and the normal chromatographic dispersion. The x-axis scales the retention time $t_R$ in minutes. In this context, it has to be noted that the displayed retention time $t_R$ shows the time elapsed since the start of the analysis which does not equal the classical retention time of the individual substances of all the multiplexed substances spent in the separator.

Fig. 3B shows an enlarged section of the chromatogram of Fig. 3A. Between ca. minute 38.5 and ca. minute 40.5 four convoluted peaks of the same sample are well visible. This shows the high reproducibility of the method and the injected volume of the sample pulses. The coding of the specific binary sequence can, thus, well be detected in the multiplexed chromatogram by a detector and/or decomposer.

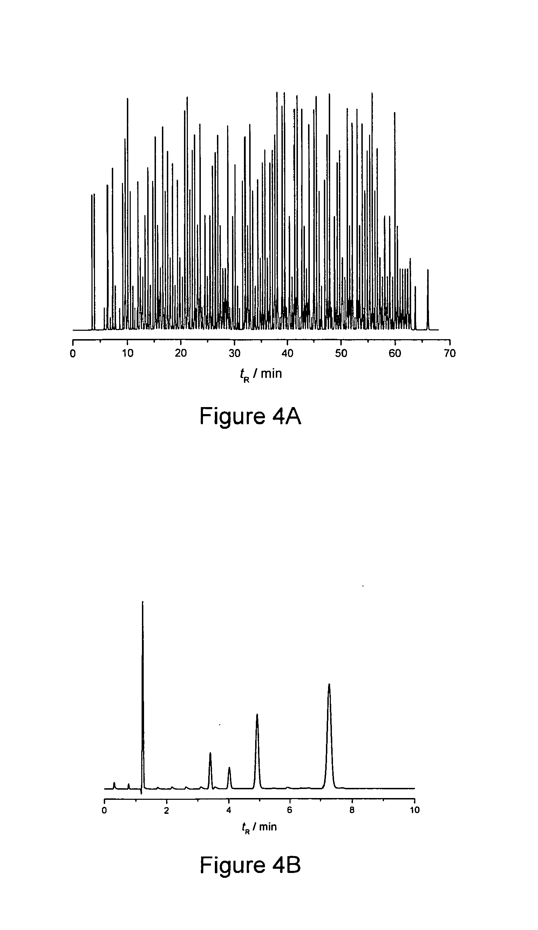

Fig. 4A shows a diagram of experimentally detected multiplexed signals in an HPLC chromatogram using an 7-bit coding and samples of different concentration. The chromatogram shows the detected signals at different heights depending on the degree of convolution. Fig. 4B shows a diagram of the chromatogram of Fig. 4A after its decomposition. The sample comprises five different substances that each result in an individual peak in the chromatogram. Since each sample injection comprises the same substances, but at different concentrations, the five peaks in the multiplexed chromatogram appear at a different height each (see Fig. 4A).

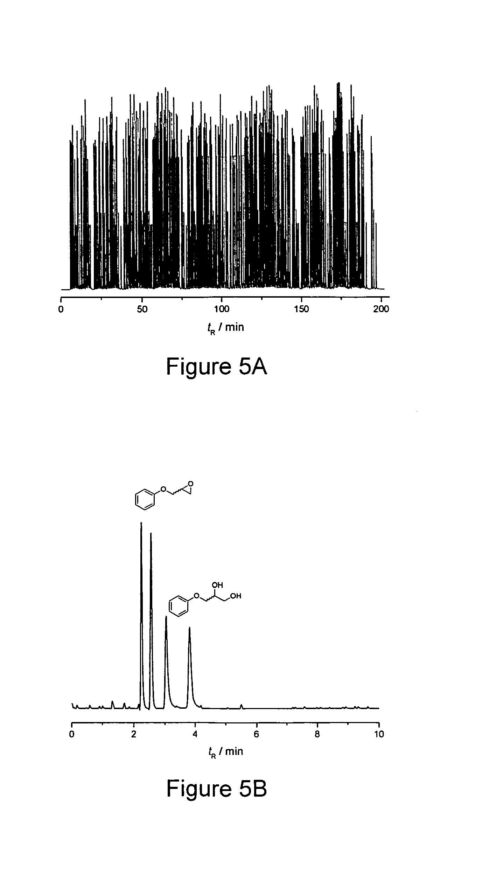

A similar example is shown in the next two figures: Fig. 5A shows a diagram of experimentally detected multiplexed signals in an HPLC chromatogram of a chiral separation at differing concentrations using an 8-bit coding at a time interval $\Delta t$ of 45 s. Fig. 5B shows a diagram of the chromatogram of Fig. 5A after its decomposition.

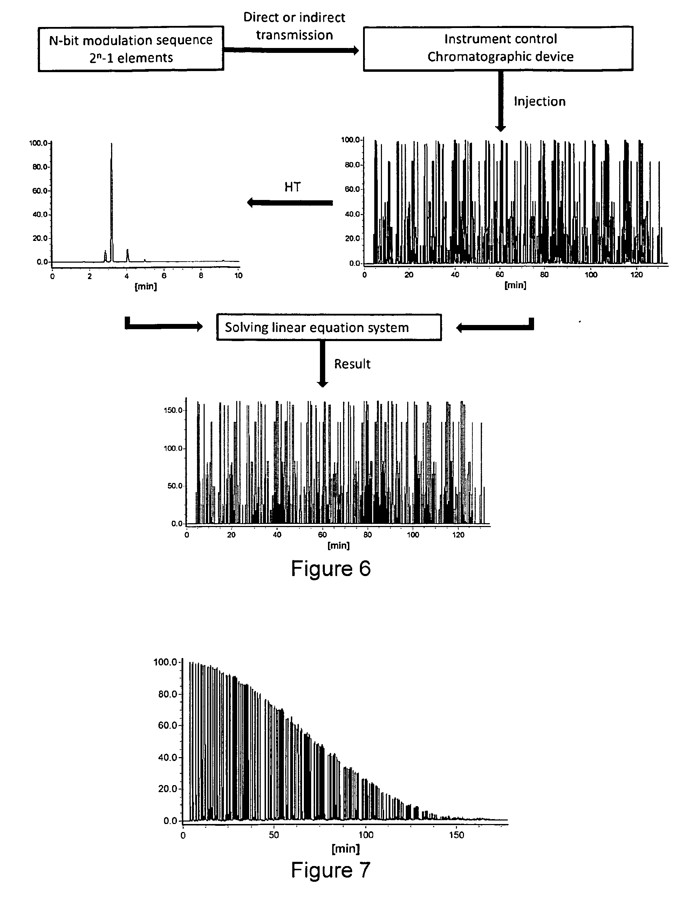

Fig. 6 shows a schematic flowchart of a method to inject encoded multiple samples in a chromatographic device and analyse them afterwards. A n-bit modulation pseudo-random sequence is generated comprising multiple differing sequence-elements. The pseudo-random sequences are transformed into specific binary sequences (by filling them with additional filling elements), according to which the different samples are injected into the separator. This results in the multiplexed chromatogram depicted on the right-hand side in Fig. 6.

A Hadamard transformation (HT) helps to decompose individual substance-mixtures. This leads to individual chromatograms for individual samples, as depicted in the middle left-hand side. Disclosure of the mathematical formalism of this multiplexing and deconvolution (decomposing) is given by DE 10 2005 050 114 which is incorporated herein. Taking into account the multiple individual chromatograms detected by executing a Hadamard transformation on the multiplexed chromatogram, and also taking into account the multiplexed chromatogram itself, final chromatograms can be obtained by solving a linear equation system. This leads to the summarized evaluated chromatogram at the bottom of Fig. 6.

In summary Fig. 6 shows a calculation pathway to deconvolute multiplexed HPLC-chromatograms to obtain separated traces of individual samples and the analytes therein.

**Fig. 7** shows a diagram of a reaction profile obtained by high-throughput HPLC multiplexing. The method allows the tracking of chemical reactions such as in industrial process analysis over a defined period of time defined by sequence length and injection interval.

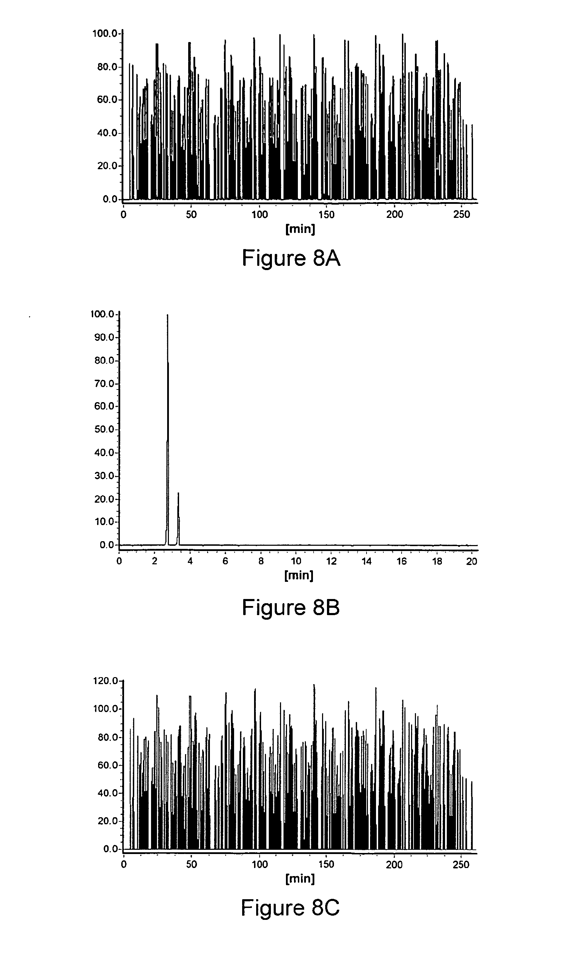

**Fig. 8A to 8C** show diagrams of experimentally detected multiplexed signals in an HPLC chromatogram using a 9-bit coding at a time interval of 30 s. 128 different samples are injected twice each. While Fig. 8A shows the multiplexed chromatogram, Fig. 8B shows the overall Hadamard transformation of the chromatogram depicted in Fig. 8A. Fig. 8C shows the fully evaluated HPLC chromatogram obtained by high-throughput multiplexing.

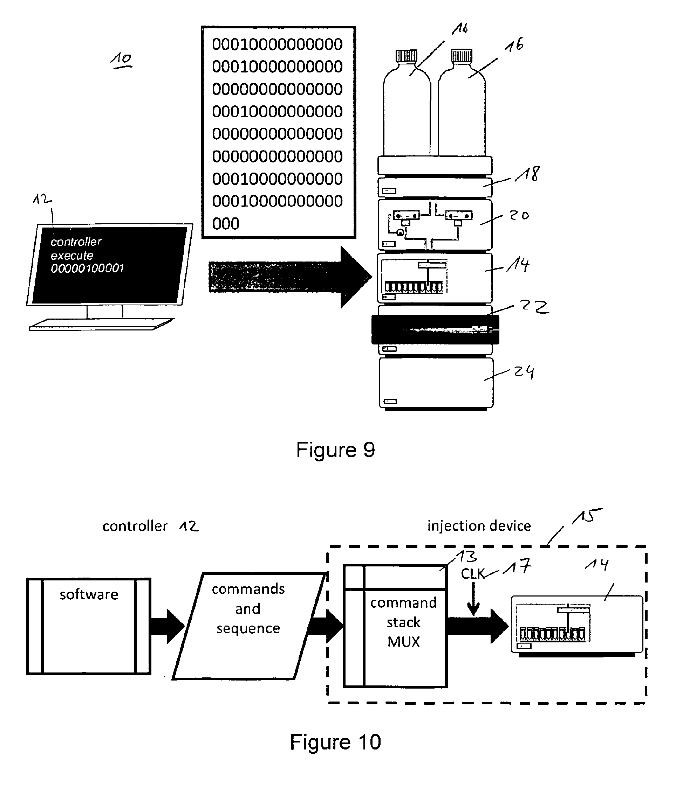

**Fig. 9** shows a schematic setup of a method to apply binary sequences to a chromatographic device 10. A sequence generator is provided as a computer 12 that generates a specific binary sequence as pseudo-random sequence. The computer 12 fills the specific binary sequence with filling elements to generate an extended specific binary sequence that is transmitted to an autosampler 14 of the chromatic device 10.

The chromatic device further comprises a pump 20, a degasifier 18, solvents 16, a column compartment 22 as separator and a detector 24.

On the computer 12, computer readable instructions are installed and uploaded into a memory of the computer 12 so it executes these computer readable instructions. The computer readable instructions result in the computer 12 further serving as a controller to control the autosampler 14 of the chromatographic device 10 to inject multiple samples according to the extended specific binary sequence.

Furthermore, the computer 12 will, after the separation and detection of the samples, function as a decomposer to calculate the chromatograms from the multiple signals of the samples detected at the detector 24.

As depicted in Fig. 9, the specific binary sequences generated preferably begin with at least one element "0" to provide the chromatographic device 10 with enough time to load the sample to be processed into the injector unit. Thus, very short reduced time intervals $\Delta t_{reduced}$ can be processed and realized by the autosampler 14 of the injector unit.

**Fig. 10** shows a further detail of the chromatographic device 10 shown by Fig. 9 in a schematic setup. In particular, the computer 12 as controller sends commands and extended specific binary sequences to an injector unit 15 of the chromatographic device 10. The injector unit 15 comprises a command stack 13 as multiplexer (MUX) and the autosampler 14.

The specific binary sequences for the modulation and the commands to control the autosampler unit are generated by software and transmitted to the command stack 13 of the injector device 15. A clock 17 controls the execution of the commands deposited in the command stack 16.

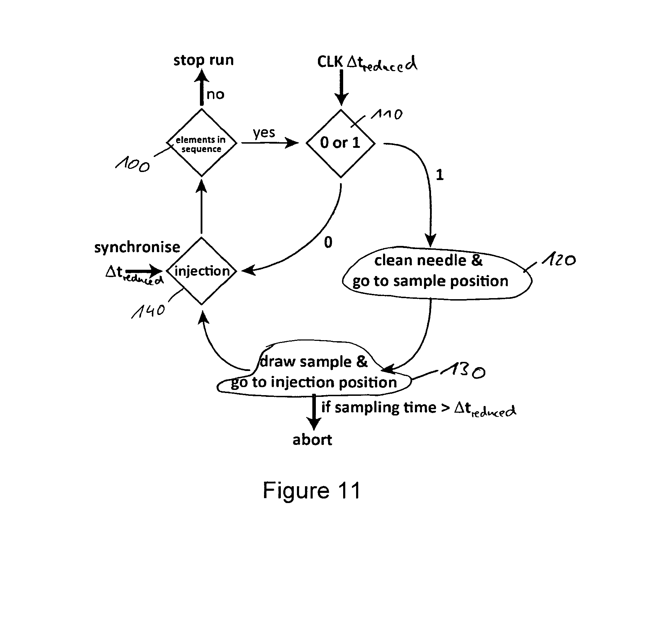

**Fig. 11** shows a schematic flowchart of a method to control an injector unit according to a binary sequence.

A specific binary sequence is generated as a modulation sequence and filled by filling elements to form an extended specific binary sequence. The commands shown in the schematic of Fig. 11 control an autosampler of a chromatographic device as separation device. Computer readable instructions comprise the extended specific binary sequence and a command loop, which analyses the elements of the extended specific binary sequence.

At step 100, the controller checks if there are elements in the extended specific binary sequence. If there are no elements, the program will stop to run. If there are elements left to process, the controller will evaluate at step 110 if the active element to be processed is an element "1" or an element "0". Furthermore, a signal of the local clock 17 of the chromatographic device 10 is received at step 110 to synchronise the process.

If the active element of the extended specific binary sequence is an element "0", no sample injection or blind injection takes place and the process proceeds with step 40.

If the active element of the extended specific binary sequence is an element "1", the sampling procedure is triggered comprising the steps of cleaning of needle and moving to a selected position of the sample at step 120, drawing the sample and going to an injection position at step 130. At step 130, the algorithm analyses the correctness of the synchronisation and, if the sampling time exceeds the predefined reduced time interval $\Delta t_{reduced}$, the execution of the sequence is aborted.

At step 140, the sample is injected at the synchronising pulse of the clock 17 (if processing an element "1"). If processing an element "0", there is no sample in the injector unit that is injected.

The process continues at step 100 in a loop. After analysing the last element of the extended specific binary sequence, a command to stop the sequence is generated following step 100.

The elements "0" and "1" depicted in the figures and the description are illustrative examples and interchangeable, so that an element "0" can be used as injection trigger and vice versa.

The method allows, e.g., the analysis of sample-mixtures with different analyte concentrations. An existing (HPLC) technique can be used (together with the additional sequencing technique). Conventional multi-well plates can be used. Thus, large sample sets and assays can be analysed with other high-throughput analysis techniques without compatibility problems.

**Reference list**

| | |
|---|---|
| 10 | chromatographic device |
| 12 | sequence generator |
| 13 | command stack |
| 14 | autosampler |
| 15 | injector unit |
| 16 | solvent |
| 17 | clock |
| 18 | degasifier |
| 20 | pump |
| 22 | column compartment |
| 24 | detector |
| $\Delta t_{reduced}$ | reduced time interval |
| $\Delta t$ | time interval |
| F | number of fillings elements |
| $h_1$, $h_2$, and $h_3$ | height in chromatogram |

**Claims**

1. Chromatographic device (10) for analysing multiple samples comprising:

   - a separator (22) for separating the multiple samples,
   - an injector unit (15) for injecting the multiple samples into the separator (22), the injector unit (15) being provided as regular injector unit for single-sample chromatography,
   - a detector (24) for detecting signals of the multiple samples after they are separated by the separator (22),
   - a sequence generator (12) for generating a specific binary sequence for each of the multiple samples,
   - a controller (12) that controls the injector unit (15) so that each of the multiple samples is injected into the separator (22) in pulses corresponding to its specific binary sequence, and
   - a decomposer (12) for decomposing the detected signals of the multiple samples by identifying at least one of the specific binary sequences in the detected signals.

2. Chromatographic device according to claim 1, wherein the controller (12) controls the injector unit (15) and the timing of the pulses according to the specific binary sequence based on computer readable instructions.

3. Chromatographic device according to claim 1 or 2, wherein the chromatographic device (10) comprises multiple injector units (15) each being provided as regular injector unit for single-sample chromatography, wherein the controller (12) controls each of the multiple injector units (15).

4. Chromatographic device according to any of the preceding claims, wherein the controller (12) controls the sample-volume injected into the separator (22) at each pulse.

5. Chromatographic device according to any of the preceding claims, comprising a timer (17) according to which the controller (12) controls the time length of the pulses in that the multiple samples are injected into the separator (22).

6. Chromatographic device according to any of the preceding claims, wherein the sequence generator (12) generates the specific binary sequence comprising substantially the same number of elements "0" and of elements "1" and generates an extended specific binary sequence by filling the specific binary sequence with a predetermined number of elements "0" or elements "1" before or after each respective element of the specific binary sequence and, wherein the controller (12) uses the extended specific binary sequence instead of the specific binary sequence to control the injector unit (15) so that each of the multiple samples is injected into the separator (22) in pulses corresponding to its extended specific binary sequence.

7. Chromatographic device according to claim 6, wherein the sequence generator (12) generates the specific binary sequence from $2^n$-1 elements, wherein $1 \leq n \leq \infty$, preferably $5 \leq n \leq 128$, more preferably $5 \leq n \leq 13$.

8. Chromatographic device according to any of the preceding claims, wherein the sequence generator (12) generates the specific binary sequence by means of an electronic circuit and/or computer readable instructions.

9. Chromatographic device according to any of the preceding claims, wherein the controller (12) drives the injector unit (15) so that each of the multiple samples is injected into the separator (22) in pulses at equidistant time intervals ($\Delta t$) corresponding to binary elements of the specific binary sequence.

10. Chromatographic device according to claim 9, wherein the equidistant time intervals ($\Delta t$) last from 500 ms to 240 s, preferably from 1 s to 60 s.

11. Method for analysing multiple samples in a chromatographic device (10) comprising the steps:

   - generating a specific binary sequence for each of the multiple samples,
   - controlling a regular injector unit (15) for single-sample chromatography so that the injector unit injects (15) each of the multiple samples into a separator (22) of the chromatographic device (10) in controlled pulses corresponding to the specific binary sequence of the sample,

- separating the multiple samples in the separator (22),

- detecting signals of the separated multiple samples, and

- decomposing the detected signals of the separated multiple samples by identifying at least one of the specific binary sequences in the detected signals.

12. Computer program product comprising computer readable instructions which when loaded and executed by a processor cause the processor to carry out the method according to claim 11.

13. Use of the method according to claim 11 for analysing multiple samples in a chromatographic device according to any of claims 1 to 10.

| Construction of a binary sequence 101001011 by software or hardware encoding | → | Filling of the sequence with n 0's or 1's between the elements 100000000010000000000000010000000001000010000 | → |

| Transmission of the sequence and command macro to control position of the autosampler as digital or electronic data by wire, wireless, USB, flash memory, etc. to the controller/ memory of the analytical device/ autosampler | → | Processing of the commands according to the precise timing of the clock of the analytical device/ autosampler | → | Detection of the multiplexed signals |

**Figure 1**

$t_R$ / min

**Figure 2**

Figure 3A

Figure 3B

Figure 4A

Figure 4B

Figure 5A

Figure 5B

Figure 6

Figure 7

Figure 8A

Figure 8B

Figure 8C

00010000000000
00010000000000
00000000000000
00010000000000
00000000000000
00000000000000
00010000000000
00010000000000
000

*10*

*12*

controller
execute
00000100001

*16*

*16*

*18*

*20*

*14*

*22*

*24*

Figure 9

controller *12*

injection device *15*

software

commands
and
sequence

*13*
CLK *17*

*14*

command
stack
MUX

Figure 10

Figure 11

**EP 2 818 859 A1**

Europäisches
Patentamt

European
Patent Office

Office européen
des brevets

# EUROPEAN SEARCH REPORT

Application Number

EP 13 00 3300

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2008/295617 A1 (STUDIENGESELLSCHAFT KOHLE MBH [DE]) 4 December 2008 (2008-12-04) * the whole document * | 1-13 | INV. G01N30/16 G01N30/86 |
| X | LAURGEAU AND F BARRAS C: "SIMULTANEOUS ANALYSIS OF TWO OR MORE SAMPLES ON THE SAME CHROMATOGRAPHIC COLUMN", CHROMATOGRAPHIA, VIEWEG UND TEUBNER VERLAG, DE, vol. 12, no. 3, 1 January 1979 (1979-01-01), pages 160-164, XP009078977, ISSN: 0009-5893, DOI: 10.1007/BF02314871 * page 162, column 2, paragraph 2 - page 163, column 2, last paragraph * * figures 4-7 * | 1-13 | |
| X | IVASK J ET AL: "Reduction of the detection limits of anions in polar ice core analysis using correlation ion chromatography with detector signal processing", JOURNAL OF CHROMATOGRAPHY, ELSEVIER SCIENCE PUBLISHERS B.V, NL, vol. 844, no. 1-2, 4 June 1999 (1999-06-04), pages 419-423, XP027232007, ISSN: 0021-9673 [retrieved on 1999-06-04] * the whole document * | 1,2,4,5, 8-13 | TECHNICAL FIELDS SEARCHED (IPC) G01N |
| X | US 3 535 084 A (ISAWA KEISUKE ET AL) 20 October 1970 (1970-10-20) * the whole document * | 1,2,4,5, 8-13 | |

-/--

The present search report has been drawn up for all claims

| Place of search | Date of completion of the search | Examiner |
|---|---|---|
| Munich | 10 October 2013 | Dedman, Emma |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

18

Europäisches
Patentamt

European
Patent Office

Office européen
des brevets

**EUROPEAN SEARCH REPORT**

Application Number

EP 13 00 3300

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SMIT ET AL: "Correlation chromatography", TRAC, TRENDS IN ANALYTICAL CHEMISTRY, ELSEVIER, AMSTERDAM, NL, vol. 2, no. 1, 1 January 1983 (1983-01-01) , pages 1-7, XP026592315, ISSN: 0165-9936, DOI: 10.1016/0165-9936(83)87065-4 [retrieved on 1983-01-01] * the whole document * | 1,11-13 | |
| A | MIHKEL KALJURAND ET AL: "Analyzing time varying flow composition using multiple input chromatography", ANALYTICA CHIMICA ACTA, vol. 348, no. 1-3, 1 August 1997 (1997-08-01), pages 203-214, XP055082952, ISSN: 0003-2670, DOI: 10.1016/S0003-2670(97)00239-0 * page 204, column 1, paragraph 2 - paragraph 3 * | 1,11-13 | |
| A | RAYMOND ANNINO: "Introduction to the Theory of Correlation Chromatography", 15 July 1985 (1985-07-15), TRACE RESIDUE ANALYSIS,, PAGE(S) 83 - 99, XP009173268, * the whole document * | 1,11-13 | TECHNICAL FIELDS SEARCHED (IPC) |

The present search report has been drawn up for all claims

| Place of search | Date of completion of the search | Examiner |
|---|---|---|
| Munich | 10 October 2013 | Dedman, Emma |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT**
**ON EUROPEAN PATENT APPLICATION NO.**                    EP 13 00 3300

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2013

| Patent document cited in search report | | Publication date | Patent family member(s) | | Publication date |
|---|---|---|---|---|---|
| US 2008295617 | A1 | 04-12-2008 | DE 102005050114 | A1 | 19-04-2007 |
| | | | EP 1994403 | A2 | 26-11-2008 |
| | | | EP 2037262 | A1 | 18-03-2009 |
| | | | EP 2042863 | A1 | 01-04-2009 |
| | | | JP 5289961 | B2 | 11-09-2013 |
| | | | JP 2009511924 | A | 19-03-2009 |
| | | | US 2008295617 | A1 | 04-12-2008 |
| | | | WO 2007045224 | A2 | 26-04-2007 |
| US 3535084 | A | 20-10-1970 | DE 1548675 | A1 | 19-03-1970 |
| | | | GB 1150266 | A | 30-04-1969 |
| | | | US 3535084 | A | 20-10-1970 |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102005050114